# EUROPEAN PATENT APPLICATION

(11) **EP 0 921 560 A2**
(43) Date of publication of application: **09.06.1999**
(21) Application number: 98309882.3
(22) Date of filing: 02.12.1998
(51) Int. Cl.: H01L 21/28, H01L 21/285, H01L 21/60

(54) **Self-aligned contact**

(30) Priority: 05.12.1997 US 67565 P
(71) Applicant: TEXAS INSTRUMENTS INC., Dallas, Texas 75243 (US)
(72) Inventor: Hong, Qi-Zhong, Dallas, Texas 75243 (US); Yang, Hong, Dallas, Texas 75248 (US); Shiau, Wei-Tsun, Plano, Texas 75023 (US); Chao, Shih-Ping, Plano, Texas 75024 (US)
(74) Representative: Potter, Julian Mark

(57) **Abstract**

An embodiment of the instant invention is a method of fabricating an electronic device formed on a semiconductor substrate, the method comprising the steps of: forming a source region and a drain region in the semiconductor substrate, the source and drain regions separated from each other by a channel region; forming a gate structure insulatively disposed over the channel portion of the substrate and adjacent to the source and the drain regions; forming a cobalt-containing material (step 102 of FIGURE 1) over the source region, the drain region, and the gate structure at a first temperature around 300 to 500 C; performing a first anneal step (step 104 of FIGURE 1) at a second temperature around 450 to 650 C for around 10 to 120 seconds so as to react a portion of cobalt-containing material with a portion of the semiconductor substrate in the source and drain regions and a portion of gate structure, the remainder of the cobalt-containing material remaining unreacted; removing the unreacted portions of the cobalt-containing material (step 106 of FIGURE 1); and performing a second anneal step (step 108 of FIGURE 1) at a third temperature around 700 to 900 C for around 10 to 120 seconds.

## Description

### FIELD OF THE INVENTION

The instant invention pertains to a semiconductor device and the fabrication and processing thereof, and more specifically, but not exclusively to a method of fabricating a silicide region.

### BACKGROUND OF THE INVENTION

Each generation of electronic devices requires faster and smaller transistors which require less power. In order to accomplish this, the source/drain regions of future transistors will have to shrink in both the horizontal and vertical directions. In addition, gate widths and heights must also shrink. Since the cross-sectional area of both the source/drain regions and the gate structures will be smaller, the resistance of these structures will increase with their decreasing sizes. Hence, a more highly conductive material must be introduced into or on these structures so as to lessen their increasing resistance. Presently, titanium silicide is formed on these structures so as to lessen their resistance for a given length of the structure. However, as the width of the structure decreases to sub 0.25 micron, the sheet resistance of the titanium silicide increases. This phenomena is due to the difficulty in the transformation of the titanium silicide layer from its C49 phase to the less resistive C54 phase for smaller width structures.

An alternative method for lower the resistivity of the source/drain and gate regions which does not suffer from this linewidth-dependence sheet resistivity problem involves forming a cobalt silicide region on the source/drain and gate regions. However, present CoSi₂ structures typically suffer at least one severe problem. Devices formed with cobalt silicide in the source/drain regions typically have higher diode leakage because of the non-uniform CoSi₂/Si interfaces. In other words, typical cobalt silicides formed on shallow source/drain areas suffer from cobalt "spiking" into the substrate. This is problematic, because transistors with higher diode leakage consume more power, especially when the device is in its "off state". In addition, this becomes even more problematic as the depth of the source/drain regions decreases.

One approach to overcome this problem involves performing a high-temperature step to deposit a cobalt layer followed by an in-situ vacuum anneal step. *See* Ken Inoue et al., *A New Cobalt Salicide Technology for 0.15 micron CMOS Using High-Temperature Sputtering and In-Situ Vacuum Annealing*, 95-445 IEDM Tech. Dig. 18.1.1 (1995). Another approach involves forming a TiN layer on the cobalt layer prior to any annealing steps and then performing a high temperature anneal step. *See* K. Goto et al., *Leakage Mechanism and Optimized Conditions of Co Salicide Process for Deep-Submicron CMOS Devices*, 95-449 Tech. Dig. 18.2.1 (1995).

### SUMMARY OF THE INVENTION

An embodiment of the instant invention is a method of fabricating an electronic device formed on a semiconductor substrate, the method comprising the steps of: forming a source region and a drain region in the semiconductor substrate, the source and drain regions separated from each other by a channel region; forming a gate structure insulatively disposed over the channel portion of the substrate and adjacent to the source and the drain regions; forming a conductor containing material over the source region, the drain region, and the gate structure at a first temperature around 300 to 500 C; performing a first anneal step at a second temperature around 450 to 650 C for around 10 to 120 seconds so as to react a portion of conductor containing material with a portion of the semiconductor substrate in the source and drain regions and a portion of gate structure, the remainder of the conductor containing material remaining unreacted; removing the unreacted portions of the conductor containing material; and performing a second anneal step at a third temperature around 700 to 900 C for around 10 to 120 seconds. Preferably, the electronic device is selected from the group consisting of: a transistor, a DRAM, a memory device, a logic device, a processor, and any combination thereof. The first temperature is, preferably, around 450 C, and the second temperature is around 300 to 399 C. The third temperature is, preferably, around 700 to 800C or 800 to 900C, and is, more preferably, around 750 C or 850 C.

Another embodiment of the instant invention is a method of fabricating a conductor containing material silicide region on a source, a drain and a conductive gate structure of a transistor formed on a semiconductor substrate, the method comprising the steps of: forming a conductor containing material over the source region, the drain region, and the gate structure at a first temperature around 300 to 500 C; performing a first anneal step at a second temperature around 450 to 650 C for around 10 to 120 seconds so as to react a portion of conductor containing material with a portion of the semiconductor substrate in the source and drain regions and a portion of gate structure, the remainder of the conductor containing material remaining unreacted; removing the unreacted portions of the conductor containing material; and performing a second anneal step at a third temperature around 700 to 900 C for around 10 to 120 seconds.

Preferably, the conductor containing material of the aforementioned embodiments comprises cobalt, or Ti, or Ni, or W, or Pt, or Pd or any combination thereof.

### BRIEF DESCRIPTION OF THE DRAWINGS

A specific embodiment in accordance with the invention will now be described, by way of example only and in which:
FIGURE 1 is a flow diagram illustrating the method of the instant invention; and
FIGUREs 2a-2d are cross-sectional views of a portion of an electronic device formed using the method of the instant invention as is illustrated in FIGURE 1.

### DETAILED DESCRIPTION OF THE DRAWINGS

While the following description of an embodiment of the instant invention is centered upon the formation of cobalt silicided regions on the source/drain regions and the gate structure, embodiments of the instant invention can be used to silicide any silicon-containing structure and may or may not be utilized with a cobalt-containing material to form the silicide regions.

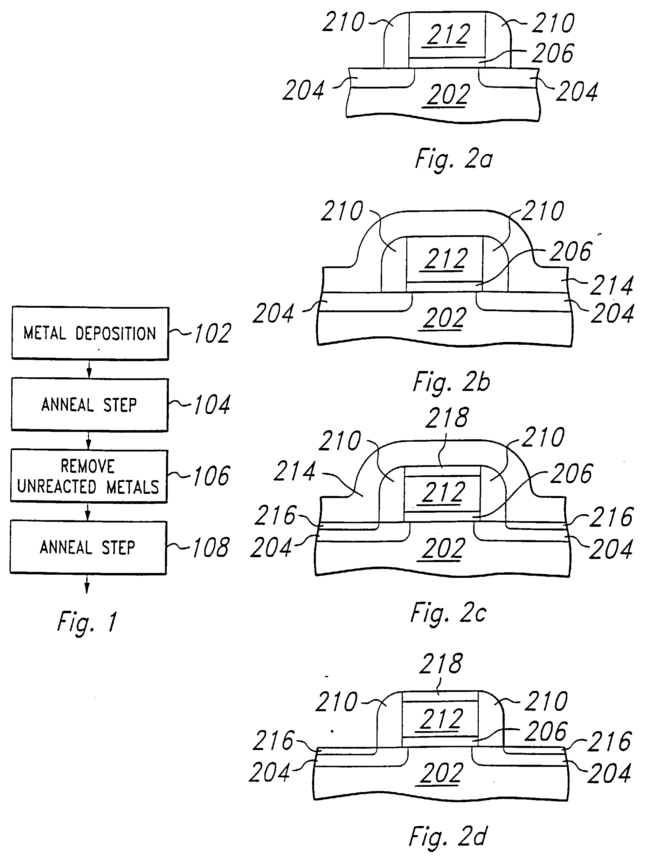

Referring to FIGURE 2a, substrate 202 is, preferably, comprised of single-crystal silicon, an epitaxial silicon layer formed over a single-crystal silicon layer, or a polycrystalline silicon layer formed over a single crystal silicon layer. Source/drain regions 204 are formed in a portion of substrate 202 by any conventional technique. Conductive gate structure 212, preferably comprised of doped or undoped polycrystalline silicon, is formed on gate insulator 206. Gate insulator 206 and sidewall insulators 210 may be comprised of an oxide, a nitride, or a combination of or a stack comprising an oxide and a nitride, but gate insulator 206 and sidewall insulator 210 do not have to be comprised of the same materials.

Referring to FIGURE 2b and step 102 of FIGURE 1, conductive layer 214 is formed over the entire device. Preferably, layer 214 is formed by either sputtering or by any other conventional deposition technique (such as chemical vapor deposition or plasma enhanced chemical vapor deposition) at an ambient temperature around 300 to 500 C (preferably around 400 to 500 C - more preferably around 450 C). Layer 214 is preferably comprised of cobalt, but it may also be comprised of Ti, Ni, W, Pt, Pd, or any combination of the above.

Referring to FIGURE 2c and step 104 of FIGURE 1, an anneal step is performed, next. Preferably, this is accomplished by subjecting the device to an ambient temperature (or a wafer temperature) of 450 to 650 C (more preferably between 500 and 600 C for around 10 to 120 seconds (more preferably around 20 to 40 seconds -even more preferably around 30 seconds). The ambient is preferably comprised of nitrogen during this anneal step. The result of this anneal step is the reaction of the cobalt from layer 214 with the silicon of source/drain regions 204 and gate region 212 so as to form silicide regions 216 and 218, respectively. These regions may be comprised of CoSi or CoSi₂. With regards to resistivity, CoSi₂ is the preferable silicide.

Referring to FIGURE 2d and steps 106 and 108 of FIGURE 1, unreacted portions of layer 214 are removed, next. This is preferably done by subjecting the wafer to HCl:H₂O₂ or H₂O₂:H₂SO₄. However, silicide regions 216 and 218 remain substantially unaffected.

In step 108, another anneal is performed so as to transform regions 216 and 218 into the more conductive CoSi₂ siliade. Preferably, step 108 is accomplished by subjecting the device to an ambient temperature of around 700 to 900 C (more preferably around 700 to 850 C - even more preferably around 800 to 850 C) for around 10 to 120 seconds (more preferably around 20 to 40 seconds - even more preferably around 30 seconds) in a nitrogen ambient. The importance of this step combined with the prior deposition and anneal steps is that it improves the diode leakage of the device without substantially increasing the source/drain series resistance.

Although specific embodiments of the present invention are herein described, they are not to be construed as limiting the scope of the invention. Many embodiments of the present invention will become apparent to those skilled in the art in light of the methodology of the specification. The scope of the invention is limited only by the claims appended. For example, electronic devices other than those specifically described herein-before may also be fabricated by and/or comprise embodiments of the invention. In particular, an embodiment may comprise an electronic device fabricated in accordance with one or combination of the appended claims.

The scope of the present disclosure includes any novel feature or combination of features disclosed therein either explicitly or implicitly or any generalisation thereof irrespective of whether or not it relates to the claimed invention or mitigates any or all of the problems addressed by the present invention. The applicant hereby gives notice that new claims may be formulated to such features during the prosecution of this application or of any such further application derived therefrom. In particular, with reference to the appended claims, features from dependent claims may be combined with those of the independent claims and features from respective independent claims may be combined in any appropriate manner and not merely in the specific combinations enumerated in the claims.

## Claims

1. A method of fabricating an electronic device formed on a semiconductor substrate, said method comprising the steps of:
forming a source region and a drain region in the semiconductor substrate, the source and drain regions separated from each other by a channel region;
forming a gate structure insulatively disposed over the channel portion of the substrate and adjacent to the source and the drain regions;
forming a conductor containing material over said source region, said drain region, and said gate structure at a first temperature around 300 to 500 C;
performing a first anneal step at a second temperature around 450 to 650 C for around 10 to 120 seconds so as to react a portion of conductor containing material with a portion of said semiconductor substrate in said source and drain regions and a portion of gate structure, the remainder of said conductor containing material remaining unreacted;
removing said unreacted portions of said conductor containing material; and
performing a second anneal step at a third temperature around 700 to 900 C for around 10 to 120 seconds.

2. The method of claim 1, wherein said electronic device is selected from the group consisting of: a transistor, a DRAM, a memory device, a logic device, a processor, and any combination thereof.

3. The method of claim 1 or claim 2, wherein said first temperature is around 450 C.

4. The method of any of claims 1 to 3, wherein said third temperature is around 700 to 800C.

5. The method of any of claims 1 to 3, wherein said third temperature is around 800 to 900C.

6. The method of claim 4, wherein said third temperature is around 750 C.

7. The method of claim 5, wherein said third temperature is around 850 C.

8. The method of any of claims 1 to 7, wherein said second temperature is around 300 to 399 C.

9. A method of fabricating a conductor containing silicide region on a source, a drain and a conductive gate structure of a transistor formed on a semiconductor substrate, said method comprising the steps of:
forming a conductor containing material over said source region, said drain region, and said gate structure at a first temperature around 300 to 500 C;
performing a first anneal step at a second temperature around 450 to 650 C for around 10 to 120 seconds so as to react a portion of conductor containing material with a portion of said semiconductor substrate in said source and drain regions and a portion of gate structure, the remainder of said conductor containing material remaining unreacted;
removing said unreacted portions of said conductor containing material; and
performing a second anneal step at a third temperature around 700 to 900 C for around 10 to 120 seconds.

10. A method of any preceding claim, wherein said conductor containing material comprises cobalt, or Ti, or Ni, or W, or Pt, or Pd, or any combination thereof.
